# EUROPEAN PATENT APPLICATION

(11) **EP 0 849 694 A1**
(43) Date of publication of application: **24.06.1998**
(21) Application number: 97203980.4
(22) Date of filing: 17.12.1997
(51) Int. Cl.: G06F 19/00, G06F 17/50

(54) **Equipment for determining the environmental impact of objects in the building sector**

(30) Priority: 17.12.1996 NL 1004805
(71) Applicant: Nederlands Institut voor Bouwbiologie en Ecologie B.V., 1400 AE Bussum (NL)
(72) Inventor: Haas, Edwin Michael, 1411 GP Naarden (NL)
(74) Representative: de Bruijn, Leendert C.

(57) **Abstract**

Equipment for determining the environmental impact of objects in the building sector, provided with a processing unit (1) and display means (2), connected to the processing means (1), input means (3) and a quantitative module (4) which is connected to the processing means (1) and is provided with quantitative environmental impact data for at least one object, and a qualitative module (5), provided with qualitative data on objects for which as yet no quantitative environmental impact data are known, which qualitative data have been compiled in the form of performance scales, a value being assigned to each performance scale, wherein the processing means (1) are equipped to compute an environmental impact value as a function of the environmental impact data and the values of the performance scales.

## Description

The invention relates to equipment for determining the environmental impact of objects in the building sector, provided with a processing unit and display means, connected to the processing means, input means and a quantitative module which is connected to the processing means and is provided with quantitative environmental impact data for at least one object, the processing means being equipped to compute an environmental impact value as a function of the environment impact data.

Equipment of this type is known in practice and has been developed by the Centrum voor Milieukunde, Rijksuniversiteit Leiden (CML; Centre for Environmental Science, University of Leiden). The known equipment makes use of a life cycle analysis, hereinafter abbreviated as LCA. The LCA method comprises a large number of criteria against which the environmental impact is measured. Some of these criteria can be evaluated quantitatively, by means of measuring specific processes. Others of these criteria can not (yet) be expressed as quantitative processes and are consequently not taken into consideration in the final evaluation.

For instance, the original LCA method devised by the CML has nine main criteria, subdivided into a total of 25 subcriteria. In the environmental parameter study carried out by Intron and commissioned by the MilieuBeraad Bouw (Environmental Advisory Council for the Building Sector), only five environmental parameters remained from the nine main criteria and of these parameters four are operational.

The known equipment has various disadvantages. Because only some of the LCA criteria have been cast in a quantitative form and because only these quantitative aspects play a role when finally forming an opinion, incorrect conclusions can be drawn. This can arise because an opinion is formed not on the basis of the complete life cycle but only on the basis of a limited number of criteria, specifically those criteria which are quantitatively measurable. The LCA method devised by the CML does provide a (virtually) complete picture in theory, but various aspects have not yet been worked out in practice.

In the practice of LCA studies it is possible only to indicate an environmental profile as the end assessment; there is no weighing of the criteria in order to arrive at one final opinion. A comparison of environmental profiles is interesting, but it is hardly possible, or is impossible, to assess a complete building by this means. A single final assessment figure is needed for this purpose and this is not provided.

Finally, the effect on health plays a very minor role in the LCA method, as a result of which it is not possible to make a choice which is based on health criteria.

The known equipment has shortcomings, mainly because said equipment processes quantitatively known data only and excludes qualitatively known data from processing.

It is therefore an aim of the invention to provide equipment of the abovementioned type with which the environmental impact of building materials, building products, building components and/or buildings can be determined, it also being possible to take account of qualitative data.

Equipment of the abovementioned type is therefore characterised according to the invention in that the equipment also comprises a qualitative module which is connected to the processing means, the qualitative module containing qualitative data on objects for which as yet no quantitative environmental impact data are known, which qualitative data have been compiled in the form of performance scales, a value being assigned to each performance scale, and wherein the processing means are equipped also to compute the environmental impact value as a function of the values of the performance scales for the qualitative data.

The equipment according to the invention provides a way of being able to use a mixture of qualitative and quantitative assessments in one system. Consequently, it is possible to give an opinion on the basis of a complete life cycle analysis and not, as is known, on the basis solely of those criteria which can be determined quantitatively.

In addition to the possibility of using a mixture of quantitative and qualitative assessments in one system, the system is also able to display an environmental profile as the end result and to provide one figure as weighted final opinion on the various criteria.

Furthermore, it is possible to evaluate health criteria separately, as a result of which a product can also be given a health assessment - an item which is becoming more important all the time - as well as an environmental assessment. It is conceivable that in the future this component could acquire a predictive character with regard to the risks of the occurrence of "building-related sickness".

Finally, it is possible for processes which are still inadequately known or even unknown to be scaled qualitatively in the system. Consequently provisional, but reasoned, assessments can nevertheless be given on the basis of a worst case analysis.

The equipment is based on a two-layer system, the first layer of which is exclusively quantitative and at present (and presumably for the next few decades) is not yet complete, but which is based on the LCA method devised by the CML. The second layer is an exclusively qualitative system.

In one embodiment of the equipment according to the invention the processing means are equipped to move qualitative data from the qualitative module to the quantitative module as soon as environmental impact data which have become available for these have been assigned.

As soon as there are gaps in knowledge in the first layer, in this embodiment recourse can be made to the qualitative system in the second layer as a means of ensuring that a complete picture will nevertheless be retained. Consequently it is ensured that an assessment always takes place on the basis of as complete a picture as possible, so that the outcomes obtained are as close as possible to the environmental impact actually caused.

Furthermore, the processing means can be equipped to remove quantitative data from the quantitative module, if the environmental impact data already assigned thereto are removed, and to move them to the qualitative module to be compiled in the form of performance scales. By this means the first layer of the system, in which the quantitative data are located, becomes increasingly more important and the outcome becomes increasingly more reliable.

The processing means can compute the environmental impact value by summing environmental impact data, one or more of the values from the performance scales being used as weighting factor.

Following on from the LCA method, the quantitative module contains, for example, environmental impact data relating to raw materials, contamination, waste and energy.

The qualitative module contains, for example, performance scales with regard to nuisance, harmful effects, recyclability, reparability, life and health.

The values from the following performance scales can, for example, be used as a multiplication factor: recyclability, reparability and life.

The invention will be explained in more detail below with reference to a few figures which are intended to illustrate the invention and not to restrict it.
Figure 1 shows equipment for determining the environmental impact of objects in the building sector in accordance with the invention;
Figure 2 shows an example of a quantitative module;
Figure 3 shows an example of a qualitative module;
Figure 4 shows a comparative graph containing environmental impact values as provided by equipment according to the prior art and equipment according to the invention.

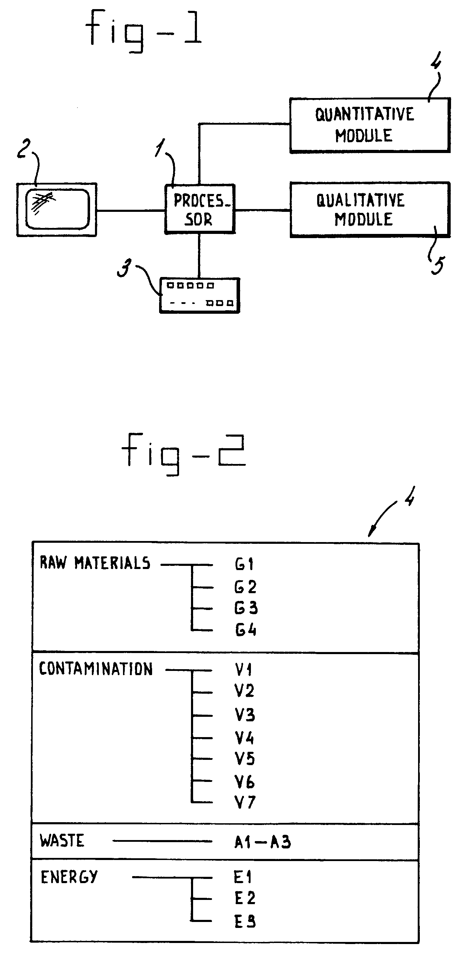

As shown in Figure 1, the equipment according to the invention comprises a processor 1 which is connected to display means 2, for example a monitor, a keyboard 3, a quantitative module 4 and a qualitative module 5. The keyboard is intended to be used by a user to enter information and can be replaced by other input means.

The quantitative module 4 contains quantitative environmental impact data for at least one object, which data have already been calculated and entered by the user.

The qualitative module 5 contains qualitative data for objects for which as yet no quantitative environmental impact data are known, which qualitative data are compiled in the form of performance scales, a value being assigned to each performance scale. This will be explained in more detail below.

According to the invention, the processing means compute an environmental impact value as a function of both environmental impact data from the quantitative module 4 and from the values of the performance scales for the qualitative data from the qualitative module 5.

A complete qualitative system has been developed that can be replaced, per criterion, by a quantitative system which is closely linked to the LCA method devised by the CML or the Intron method derived therefrom, as developed as the request of the Environmental Advisory Council for the Building Sector.

The ultimate aim is to obtain two systems which both provide complete cover, the quantitative system representing the highest level of accuracy and the qualitative system providing cover insofar as no quantitative statements are possible. The two systems together represent the complete system.

The emphasis in present practice is on incomplete quantitative systems, which is why it is chosen here to develop a complete system. Within the framework of this research for a doctoral thesis, however, this is exclusively a qualitative system.

The LCA method devised by the CML in Leiden has been retained as the guiding principle for the assessment criteria. A few aspects of this system have been modified.

There is an Environment & Health model, which has two outcomes, one in respect of environmental criteria and one in respect of health criteria, which is also termed the TWIN model.

The system is a layered system, it being possible to switch between the different layers, i.e. the qualitative layer and the quantitative layer. As more knowledge in the quantitative sense becomes available, the focus will shift toward the quantitative system; initially the focus will lie on the qualitative system.

It is possible to give an objective assessment of the environmental qualities of a building material only to a limited extent. Many quantitative data are still lacking and for the time being can be assessed only via the qualitative route. In order as far as possible to define the boundaries of this subjective aspect which is inherent in a qualitative method, the environmental and health criteria have been subdivided into subcriteria. For each subcriterion a performance description has been made in various levels. Depending on the performance level described, environmental impact points are assigned. The environmental impact points for the individual subcriteria are aggregated for each environmental or health criterion to obtain one figure per criterion.

The various environmental and health criteria are not all of equal weight, which is why weighting factors have preferably been introduced to enable a comparable unit per building material or building product to be obtained as the end result.

Incidentally, it is also possible to omit the weighting and to display only an environmental profile as the end result.

### 1. Assessment criteria

The model used in the equipment according to the invention has various layers/levels of assessment criteria:
-- *Main criteria (layer 1)*
   The first layer of the matrix consists of an X and a Y axis:
   - environmental and health criteria, which are also termed eco-toxicity and human toxicity.
   - life cycle phases
   Said layer 1 can, in turn, be subdivided into the following sublayers:
-- *Environmental criteria (layer 2a)*
   Layer 2a consists of a breakdown of the environmental criteria of layer 1. The environmental criteria have been taken from the CML LCA method, with the proviso that the nuisance component has been expanded to nuisance and harmful effect.
   The environmental criteria are:
   - raw materials
   - contamination
   - waste
   - nuisance
   - harmful effects
   - energy
   - recyclability
   - reparability (or level of maintenance requirement)
   - life
-- *Health criteria (layer 2b)*
   Layer 2b consists of a breakdown of the health criteria from layer 1. Since the CML LCA method takes hardly any account of these aspects, these criteria are a completely new addition. In health scientific research it is customary to use a breakdown into three categories of agents, i.e. physical, chemical and biological agents. The ARBO (Dutch Health and Safety at Work Act) criteria of ergonomics and safety have been added to these.
   The health criteria are:
   - physical agents
   - chemical agents
   - biological agents
   - ergonomics
   - safety
-- - *Life cycle criteria (layer 2c)*
   Layer 2c consists of a breakdown of part of layer 1 into a number of known criteria which, sometimes with a slightly modified interpretation, have been taken from the CML LCA method.
   The life cycle phases are:
   - raw material extraction
   - production of material (or product or building component)
   - construction of the building
   - use and maintenance of the building (including renovation or change of use)
   - demolition of the building (and re-use or further use)
   - waste processing
*Subdivision of environmental criteria (layer 3a)*
Layer 3a forms a further subdivision of the environmental criteria of layer 2a.
The subdivision of the environmental criteria into environmental subcriteria is as follows:
*raw materials*
- exhaustion of biotic raw materials (CML refers to this as exhaustion of scarce renewable raw materials)
- exhaustion of abiotic raw materials (CML refers to this as exhaustion of non-renewable raw materials)
- rate of exhaustion (in the CML method this is the total quantity of raw materials used, which is less relevant data than the rate of exhaustion)
- location/extraction site (this is an added criterion based on a preference for regional material)
*contamination*
Because it has been elected here to make use of the Eco indicator 95, i.e. a method for weighting environmental effects which have a harmful effect on eco systems and human health the subcriteria for this criterion are not the same as those in the CML LCA method. The subcriteria are:
- acidification
- contamination by fertilisers
- greenhouse effect
- adverse effect on the ozone layer
- summer and winter smog (this is an added criterion)
- heavy metals and pesticides (this is an added criterion)
- heat
*waste* - waste before treatment - final waste
- hazardous waste (CML still refers to this as chemical waste; it has been brought into line with current terminology)
*nuisance*
- stench and odour
- noise/vibration
- disaster - external to process (health and safety aspects have been separated off here and are covered under the separate heading of health criteria)
- disaster - internal to process (added criterion)
- light
*adverse effect on nature and landscape*
Whereas this aspect is a subcriterion in the CML method, it is incorporated here as a separate criterion, with a few subcriteria. For the sake of clarity and because this is an important item, it is incorporated here as an independent criterion and weighed.
- area taken up
- nature and complexity of the eco system (new subcriterion; fragmentation of landscape falls under area taken up)
- degree of restorability/disruption
*energy*
- exhaustion of non-renewable energy carriers
- type of energy carrier (newly added; it is important to make a distinction between coals, lignite, oil, gas, hydropower and nuclear energy)
- total quantity of energy consumed
*recyclability*
This aspect has been completely redefined in accordance with the definitions proposed by a working party of the German DIN (German Standards Organisation) and expressed in the catalysis report entitled *Das recycling-fähige Haus (The recyclable house),* a study commissioned by the Ministerium für Bauen und Wohnen (Ministry of Building and Housing) of North Rhine-Westphalia.
- re-use at product level (re-use of the spent product for the same purpose, without changing the parts; for example re-installation of a window frame and window)
- further use at product level (re-use of the spent product for another purpose, virtually without making any changes; for example use of a window as cover for a greenhouse)
- reprocessing at raw material level (repeated use of collected building and demolition waste and production waste in a similar production process; the raw material is processed to produce a similar product; for example waste paper becomes paper, waste glass becomes glass)
- further processing at raw material level (the use of collected building and demolition waste and production waste in a production process which has not yet been completed; usually this is associated with a reduction in the value of the original material, or downcycling; for example PVC recycling)
*reparability or level of maintenance required*
This aspect is not further subdivided in the CML LCA method, but is here:
- maintenance cycle (the important aspect is how frequently maintenance has to be carried out)
- percentage replacement (the quantity of material which is consumed during maintenance is also of importance)
*life*
The CML LCA method uses only the technical life as a criterion; it is a justifiable question as to whether the criterion as far as environmental impact is concerned should not be the economic life cycle, since this is frequently (much) shorter than what is technically possible.
- technical life (the technical life is used as the starting point)
- economic life (it will be possible optionally to enter this life in the equation to enable various alternatives to be compared with one another).

### Subdivision of health criteria (layer 3b)

Layer 3b forms a further subdivision of the health criteria in layer 2b. At this level the method differs substantially from the CML LCA method.
The subdivision of the health criteria into health aspects is as follows:
*physical agents*
- electromagnetic fields (to what extent is the material conductive to electromagnetic fields)
- electrostatic fields (to what extent can the material build up a static charge and what is the order of magnitude of this charge)
- static magnetic fields (to what extent can the material build up a static charge and what is the order of magnitude of this charge)
- radon and radioactivity (to what extent do these phenomena occur)
- humidity balance (to what extent is a material hygroscopic or completely vapour-tight and to what extent does this occur)
*chemical agents*
- solid chemical agents (to what extent can these be released and to what degree)
- liquid chemical agents (to what extent can these be released and to what degree)
- gaseous chemical agents (to what extent can these be released and to what degree)
*biological agents*
- bacteria (is the material bactericidal or is it a material that promotes bacterial growth)
- viruses (see above)
- parasites (see above)
- moulds (under what conditions can mould formation take place)
*ergonomics*
- lifting (how heavy are the building products concerned, how easy are they to transport and what aids are available and/or needed)
- working posture (is the way the material is handled, in all cases during its use, such that an unhealthy working posture has to be adopted)
*safety*
- accidents (what is the risk of accidents and disasters and what protection or safety features are necessary to enable work to be carried out safely)
- screening/protection (what personal screening or protection has to be used when working with this product)

### Eco-toxicity or environmental criteria in matrix form

Not all criteria and subcriteria are important at every stage. It can be seen from the following matrix which criteria and subcriteria play a role at which stage.

Energy plays a role in all stages. On the basis of practical considerations, it has been elected to include energy only for those stages for which data are known.

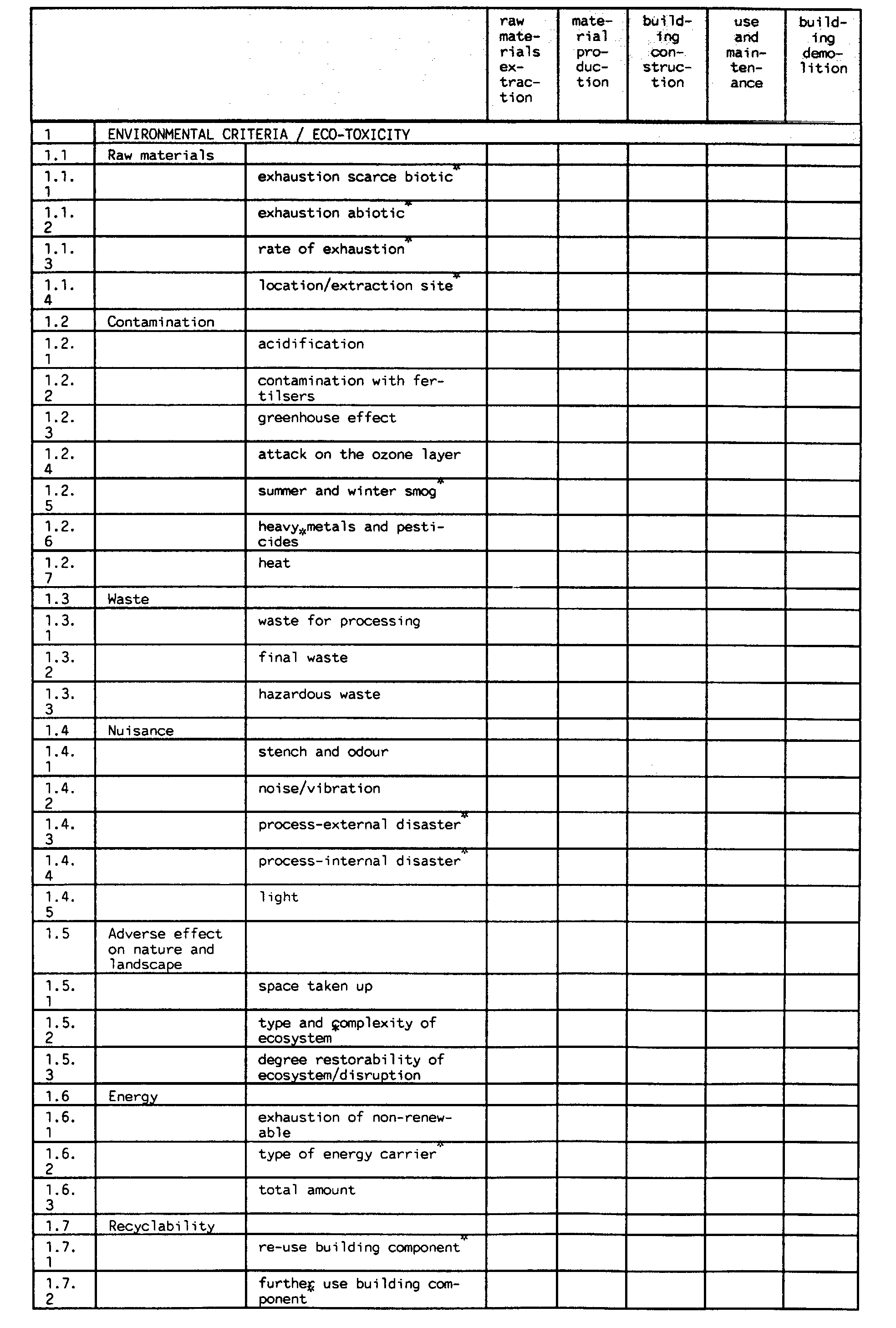

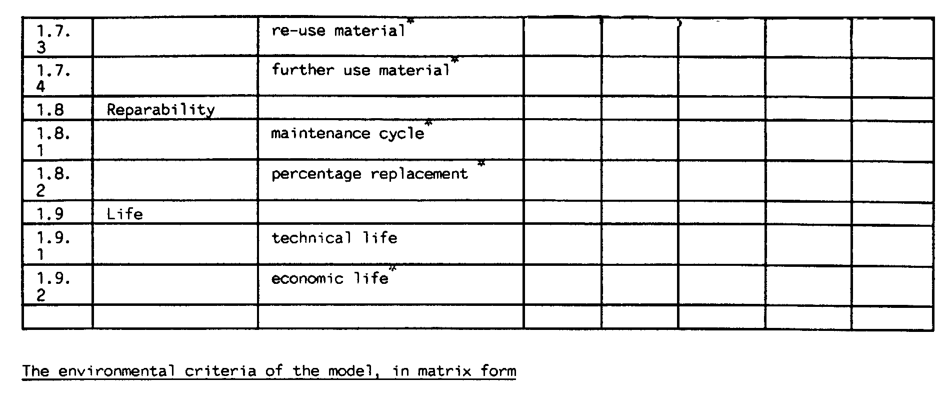

### Human toxicity and health criteria in matrix form

Health criteria also do not play a role in all stages. It can be seen from the following matrix when a certain criterion or subcriterion plays a role.

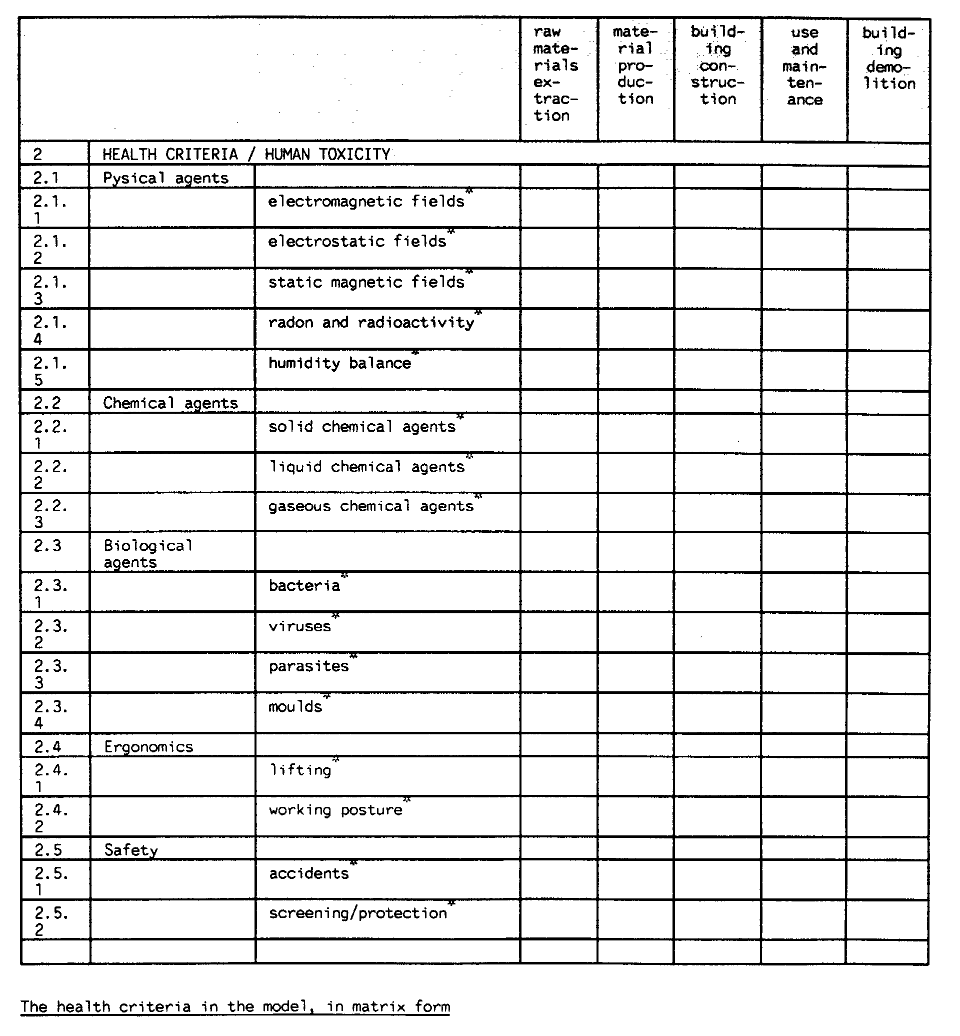

### 2. Description of eco-toxicity performance levels

A description of the performance levels in the form of environmental impact levels is given below.

As already concluded above, it is desirable for the method to follow on as closely as possible from the CML LCA method. To this end the terminology has been amended, but the main criteria will be taken over as far as possible. There are possibilities for a freer interpretation when subdividing the main assessment criteria into assessment subcriteria.

The performance descriptions must offer the possibility of incorporating and evaluating already known results of life cycle analyses which have been performed, as well as values which are still unknown and estimated.

### raw materials

In the final classification model, the raw materials component is split into four subcriteria; the comparison with the criteria used by CML is indicated in each case.

| No. | Final classification model | LCA term used by CML |
|---|---|---|
| G1 | Exhaustion of biotic raw materials | Exhaustion of scarce renewable raw materials |
| G2 | Exhaustion of abiotic raw materials | Exhaustion of non-renewable raw materials |
| G3 | Rate of exhaustion | Total quantity of raw materials consumed |
| G4 | Location/extraction site (regional as opposed to global) | |

### G1. Exhaustion of biotic raw materials

Ranking in levels has always been carried out such that there is a certain safety margin with regard to exhaustion being reached. This is necessary because it can be seen from the literature that substantial differences can exist in the estimation of extractable quantities and stocks.

| Raw materials | Exhaustion of biotic raw materials | Points |
|---|---|---|
| Level 1 | New growth appreciably greater (> 4×) than global consumption or | 2 |
| | recycled product or waste product from other processes as raw material | |
| Level 2 | New growth greater (2-4×) than global consumption | 4 |
| Level 3 | New growth comparable with global consumption (0-2× greater) | 8 |
| Level 4 | Consumption greater (0-2×) than new growth | 16 |
| Level 5 | Consumption appreciably greater (2-4×) than new growth | 32 |
| Level 6 | Over-use, consumption appreciably greater (4-8×) than new growth | 64 |
| Level 7 | Serious over-use, consumption appreciably greater (> 8×) than new growth | 128 |

### G2. Exhaustion of abiotic raw materials

Here it has been elected to assess the actual extraction site. If this extraction site becomes increasingly exhausted, the material will have an increasingly poor score with regard to this aspect. As soon as extraction is switched to another extraction site with greater stocks, the score can be adjusted, with simultaneous adjustment of the location/extraction site subcriterion.

| Raw materials | Exhaustion of abiotic raw materials | Points |
|---|---|---|
| Level 1 | Virtually inexhaustible, extraction site has stocks for > 200 years or recycled or waste product from other processes as raw materials | 2 |
| Level 2 | Substantial stocks, extraction site has stocks for between 101 and 200 years | 4 |
| Level 3 | Exhaustible, extraction site has stocks for between 71 and 100 years | 8 |
| Level 4 | Exhaustible, extraction site has stocks for between 50 and 70 years | 16 |
| Level 5 | Exhaustible, extraction site has stocks for less than 50 years and the material concerned is an easily replaceable raw material in the relevant ecosystem | 32 |
| Level 6 | Exhaustible, extraction site has stocks for less than 50 years and the material concerned is a raw material which is difficult to replace in the relevant ecosystem | 64 |
| Level 7 | Exhaustible, extraction site has stocks for less than 50 years and the material concerned is an irreplaceable raw material in the relevant ecosystem | 128 |

### G3. Rate of exhaustion

In this context it is important to use the correct definition. It is customary to take as a basis the ratio of current consumption to the economically extractable stocks currently known. The following level ranking can be derived from this:

| Raw materials | Rate of exhaustion | Factor |
|---|---|---|
| Level 1 | Ratio of economically extractable stocks: current consumption > 200 | 1.00 |
| Level 2 | Ratio of economically extractable stocks: current consumption 151-200 | 4.00 |
| Level 3 | Ratio of economically extractable stocks: current consumption 101-150 | 6.00 |
| Level 4 | Ratio of economically extractable stocks: current consumption 71-100 | 8.40 |
| Level 5 | Ratio of economically extractable stocks: current consumption 51-70 | 12.00 |
| Level 6 | Ratio of economically extractable stocks: current consumption 31-50 | 20.00 |
| Level 7 | Ratio of economically extractable stocks: current consumption < 30 | 40.00 |

### G4. Location/extraction site

On the basis of ecological considerations it is preferable to use regional building materials for building. The extraction site plays a clear role here.

| Raw materials | Location/extract site | Points |
|---|---|---|
| Level 1 | The Netherlands, Belgium, Lower Saxony, North Rhine-Westphalia | 25 |
| Level 2 | Rest of Germany, Austria, Switzerland, Great Britain, France, Luxembourg, Denmark | 80 |
| Level 3 | Southern and Eastern Europe and Scandinavia | 150 |
| Level 4 | North Africa, Middle East, West Asia | 500 |
| Level 5 | Central Africa, Central Asia, North America | 800 |
| Level 6 | South and East Asia, Central America and South America, South Africa | 1,100 |
| Level 7 | Australia and New Zealand | 1,600 |

### Contamination

The contamination criterion has been subdivided into seven subcriteria. Six of these seven criteria have been taken from the report entitled *De Eco-indicator 95 (The Eco-indicator 95),* a method for weighting environmental effects which have an adverse effect on ecosystems and human health on a European scale. Within the environmental criterion of contamination, the Eco-indicator 95 aggregates the various subcriteria to one figure. The following choices were made in the context of the Eco-indicator 95 and these are taken over here unchanged:
"- Alleen effecten die op Europese schaal leiden tot aantasting van de menselijke gezondheid en van ecosystemen worden beoordeeld. Dit betekent dat de uitputbaarheid van grondstoffen, van ruimtebeslag van afval en lokale effecten niet worden beoordeeld. De emissies ten gevolge van de winning en het gebruik van grondstoffen alsmede de emissies van de afvalverwerking worden wel meegenomen. Fysieke landschapsaantasting kon om praktische reden niet worden meegewogen.
- De toxiciteitscores zijn opnieuw gedefinieerd. Niet alle effecten die in de NOH-handleiding zijn gedefinieerd lenen zich voor weging. Wintersmog, pesticiden, carcinogeniteit en zware metalen zijn in de plaats gekomen van humane toxiciteit en eco-toxiciteit Stoffen die op de arbeidsplaats wel, maar daarbuiten geen probleem opleveren zijn niet meegewogen.
- De weging is gebaseerd op de afstand tussen de huidige en de streefwaarde voor een effect (Distance-to-Target). Hoe groter die afstand des te ernstiger is het effect. De streefwaarde is gebaseerd op een analyse van de schade die een effect op Europese schaal veroorzaakt. Het weegprincipe is gedurende het project geanalyseerd en sterk verbeterd. De gegevens voor het vaststellen van de weegfactoren zijn voornamelijk gebaseerd op gegevens van het RIVM, de OECD en Eurostat. Aan de keuze van de wegingsmethode is een uitgebreide analyse van bestaande weegmethoden vooraf gegaan." (Translation: "- Only effects which on a European scale lead to an adverse effect on human health and ecosystems are assessed. This means that the exhaustibility of raw materials, of the space taken up by waste and local effects are not assessed. The emissions as a consequence of the extraction and use of raw materials and the emissions resulting from waste treatment are taken into account. For practical reasons it was not possible to take physical adverse effects on the landscape into account.
- The toxicity scores have been redefined. Not all effects which are defined in the NOH guidelines lend themselves to weighting. Winter smog, pesticides, carcinogenicity and heavy metals have replaced human toxicity and ecotoxicity. Substances which give rise to a problem in the workplace but not outside it have not been taken into account.
- The weighting is based on the gap between the current and the target value for an effect (distance-to-target). The greater this gap the more serious is the effect. The target value is based on an analysis of the damage which an effect causes on a European scale. The weighting principle was analysed during the project and substantially improved. The data for determination of the weighting factors have mainly been based on data from the RIVM (Dutch Institute of Public Health and Environmental Hygiene), the OECD and Eurostat. An extensive analysis of existing weighting methods preceded the selection of the weighting method.")

### (Taken from the Eco-indicator 95 to this point).

Various assumptions will have to be made to make the model according to the invention suitable for the Eco-indicator.
- The Eco-indicator is based on the (unproven) assumption that there is a linear relationship between the amount of contamination and the effects caused by this contamination. There are indications from recent research that this linear relationship is possibly incorrect and it is more likely that a sort of S-curve is produced as the relationship between quantity of contamination and the associated effect, but possibly this relationship could also be exponential.
- The model according to the invention is based on the (likewise unproven) assumption that a quadratic relationship exists. Should this relationship not exist, the selection of this relationship can still be defended because the most severe contamination signifies an additional impact on the environment, which comes down to the fact that the greatest deviation from the socially acceptable is assigned the greatest number of environmental impact points.
- So that the Eco-indicator can be used, a coincidence point between the proposed level rankings and the Eco-indicator 95 has been specified; this coincidence point is at the boundary between level 6 and level 7.
- The quantities of emissions have in each case been so chosen that the next level has twice the volume of emissions of the previous level. The level ranking has been matched to the Eco-indicator 95 so that the Eco-indicator 95 weighting factors for aggregation can always be used.
- The unit in which the emissions released by the substance concerned are expressed is kg per tonne end product.

| No. | Final classification model | LCA term used by CML |
|---|---|---|
| V1 | Acidification | Acidification |
| V2 | Contamination with fertilisers | Contamination with fertilisers |
| V3 | Greenhouse effect | Greenhouse effect |
| V4 | Attack on the ozone layer | Attack on the ozone layer |
| V5 | Summer and winter smog | Human toxicity |
| V6 | Heavy metals and pesticides | Toxicity to flora and fauna |
| V7 | Heat | Waste heat |
| V8 | - | Radiation (included under health) |

### V1. Acidification

The two most important chemicals responsible for acidification are SO₂ and NO_{×}, which are liberated during combustion processes of, inter alia, fossil fuels. They can be regarded as indicators for acidification of the environment. The two indicators are summed.

| Contamination | Acidification by SO₂ | Points |
|---|---|---|
| Level 1 | Very low SO₂ emissions, < 2 | 2 |
| Level 2 | Low SO₂ emissions, 2-4 | 4 |
| Level 3 | Moderate SO₂ emissions, 4.1-8 | 8 |
| Level 4 | Appreciable SO₂ emissions, 8.1-16 | 16 |
| Level 5 | Substantial SO₂ emissions, 16.1-32 | 32 |
| Level 6 | Severe SO₂ emissions, 32.1-64 | 64 |
| Level 7 | Very severe SO₂ emissions, > 64 | 128 |

| Contamination | Acidification by fertilisers - NO_{×} | Points |
|---|---|---|
| Level 1 | Very low NO_{×} emissions, < 1.25 | 0.87 |
| Level 2 | Low NO_{×} emissions, 1.25-2.5 | 1.75 |
| Level 3 | Moderate NO_{×} emissions, 2.51-5 | 3.5 |
| Level 4 | Appreciable NO_{×} emissions, 5.1-10 | 7 |
| Level 5 | Substantial NO_{×} emissions, 10.1-20 | 14 |
| Level 6 | Severe NO_{×} emissions, 20.1-40 | 28 |
| Level 7 | Very severe NO_{×} emissions, > 40 | 56 |

### V2. Contamination with fertilisers

NO_{×} emissions and the release of phosphorus (P) are to be regarded as indicators for contamination with fertilisers. A significant proportion of this is caused by agricultural (over) fertilisation. This will be a subcriterion which will occur less frequently in the case of building materials and building products. Here again the two indicator chemicals have to be summed.

| Contamination | Contamination with fertilisers - NO_{×} | Points |
|---|---|---|
| Level 1 | Very low NO_{×} emissions, < 1.25 | 0.16 |
| Level 2 | Low NO_{×} emissions, 1.25-2.5 | 0.33 |
| Level 3 | Moderate NO_{×} emissions, 2.51-5 | 0.65 |
| Level 4 | Appreciable NO_{×} emissions, 5.1-10 | 1.3 |
| Level 5 | Substantial NO_{×} emissions, 10.1-20 | 2.6 |
| Level 6 | Severe NO_{×} emissions, 20.1-40 | 5.2 |
| Level 7 | Very severe NO_{×} emissions, > 40 | 10.4 |

| Contamination | Contamination with fertilisers - P | Points |
|---|---|---|
| Level 1 | Very low P emissions, < 0.036 | 0.04 |
| Level 2 | Low P emissions, 0.036-0.073 | 0.07 |
| Level 3 | Moderate P emissions, 0.074-0.15 | 0.15 |
| Level 4 | Appreciable P emissions, 0.16-0.29 | 0.30 |
| Level 5 | Substantial P emissions, 0.30-0.58 | 0.58 |
| Level 6 | Severe P emissions, 0.59-1.16 | 1.16 |
| Level 7 | Very severe P emissions, > 1.16 | 2.33 |

### V3 Greenhouse effect

A substantial proportion of the greenhouse effect is caused by the release of CO₂ and (H)CFCs. CO₂ is released, inter alia, on combustion of fossil fuels and (H)CFCs are released from building products such as plastic foams. The building sector thus plays a major role here. The two indicators are summed.

| Contamination | Greenhouse effect - CO₂ | Points |
|---|---|---|
| Level 1 | Very low CO₂ emissions, < 55 | 55 |
| Level 2 | Low CO₂ emissions, 55-111 | 111 |
| Level 3 | Moderate CO₂ emissions, 112-222 | 222 |
| Level 4 | Appreciable CO₂ emissions, 223-444 | 444 |
| Level 5 | Substantial CO₂ emissions, 445-889 | 889 |
| Level 6 | Severe CO₂ emissions, 890-1,778 | 1,778 |
| Level 7 | Very severe CO₂ emissions, > 1,778 | 3.555 |

| Contamination | Greenhouse effect - CFC | Points |
|---|---|---|
| Level 1 | Very low CFC emissions, < 4.45 | 4.45 |
| Level 2 | Low CFC emissions, 4.45-8.89 | 8.9 |
| Level 3 | Moderate CFC emissions, 8.90-17.78 | 17.78 |
| Level 4 | Appreciable CFC emissions, 17.79-35.55 | 35.5 |
| Level 5 | Substantial CFC emissions, 35.56-71.11 | 71.1 |
| Level 6 | Severe CFC emissions, 71.12-142.22 | 142.2 |
| Level 7 | Very severe CFC emissions, > 142.22 | 284.4 |

### V4. Attack on the ozone layer

Important indicator chemicals for the attack on the ozone layer are once again the (H)CFCs, which are released mainly by plastic foams. Despite the fact that the use of CFCs was banned in 1995, it will still be years before the CFCs produced and already processed will no longer be released and this item will thus become less important.

| Contamination | Attack on the ozone layer - CFC | Points |
|---|---|---|
| Level 1 | Very low CFC emissions, < 4.45 | 4.45 |
| Level 2 | Low CFC emissions, 4.45-8.89 | 8.9 |
| Level 3 | Moderate CFC emissions, 8.90-17.78 | 17.78 |
| Level 4 | Appreciable CFC emissions, 17.79-35.55 | 35.5 |
| Level 5 | Substantial CFC emissions, 35.56-71.11 | 71.1 |
| Level 6 | Severe CFC emissions, 71.12-142.22 | 142.2 |
| Level 7 | Very severe CFC emissions, > 142.22 | 284.4 |

### V5. Summer and winter smog

The most important indicators for summer smog are polycyclic aromatic hydrocarbons and VOS. Winter smog is often caused by an excess of particulates and SO₂ in the air. Once again all items must be summed to obtain a complete picture.

| Contamination | Summer smog - polycyclic aromatic hydrocarbons (PAHC) | Points |
|---|---|---|
| Level 1 | Very low PAHC emissions, < 0.57 | 0.43 |
| Level 2 | Low PAHC emissions, < 0.57-1.14 | 0.87 |
| Level 3 | Moderate PAHC emissions, 1.15-2.29 | 1.74 |
| Level 4 | Appreciable PAHC emissions, 2.30-4.57 | 3.48 |
| Level 5 | Substantial PAHC emissions, 4.58-9.14 | 6.96 |
| Level 6 | Severe PAHC emissions, 9.15-18.29 | 13.92 |
| Level 7 | Very severe PAHC emissions, > 18.30 | 27.83 |

| Contamination | Summer smog - VOS (not yet operable in Eco-indiciaton 95) | Points |
|---|---|---|
| Level 1 | Very low VOS emissions, | |
| Level 2 | Low VOS emissions, | |
| Level 3 | Moderate VOS emissions, | |
| Level 4 | Appreciable VOS emissions, | |
| Level 5 | Substantial VOS emissions, | |
| Level 6 | Severe VOS emissions, | |
| Level 7 | Very severe VOS emissions, | |

| Contamination | Winter smog - SO₂ | Points |
|---|---|---|
| Level 1 | Very low SO₂ emissions, < 2 | 2 |
| Level 2 | Low SO₂ emissions, 2-4 | 4 |
| Level 3 | Moderate SO₂ emissions, 4.1-8 | 8 |
| Level 4 | Appreciable SO₂ emissions, 8.1-16 | 16 |
| Level 5 | Substantial SO₂ emissions, 16.1-32 | 32 |
| Level 6 | Severe SO₂ emissions, 32.1-64 | 64 |
| Level 7 | Very severe SO₂ emissions, > 64 | 128 |

| Contamination | Winter smog - particulates | Points |
|---|---|---|
| Level 1 | Very low particulate emissions, < 4.44 | 4.45 |
| Level 2 | Low particulate emissions, 4.45-8.88 | 8.90 |
| Level 3 | Moderate particulate emissions, 8.89-17.78 | 17.78 |
| Level 4 | Appreciable particulate emissions, 17.79-35.55 | 35.55 |
| Level 5 | Substantial particulate emissions, 35.56-71.11 | 71.10 |
| Level 6 | Severe particulate emissions, 71.12-142.22 | 142.20 |
| Level 7 | Very severe particulate emissions, > 142.22 | 284.40 |

### V6. Heavy metals and pesticides

Heavy metals and pesticides are actually to be considered individually. The Eco-indicator 95, which has already been mentioned, also does so, but subsequently still sums these too. Since the Eco-indicator is being followed as closely as possible here, the two subcriteria have been combined here, so that they can be regarded as one criterion during aggregation. Important indicator chemicals for heavy metals are lead (Pb) and cadmium (Cd) and the main indicator for the pesticides is DDT, a typical agricultural poison and therefore mainly also used in products which are produced agriculturally. The points from the three tables are added together.

| Contamination | Heavy metals - Pb | Points |
|---|---|---|
| Level 1 | Very low Pb emissions, < 0.05 | 0.05 |
| Level 2 | Low Pb emissions, 0.05-0.1 | 0.1 |
| Level 3 | Moderate Pb emissions, 0.11-0.21 | 0.2 |
| Level 4 | Appreciable Pb emissions, 0.22-0.42 | 0.4 |
| Level 5 | Substantial Pb emissions, 0.43-0.84 | 0.8 |
| Level 6 | Severe Pb emissions, 0.84-1.68 | 1.7 |
| Level 7 | Very severe Pb emissions, > 1.68 | 3.4 |

| Contamination | Heavy metals - Cd | Points |
|---|---|---|
| Level 1 | Very low Cd emissions, < 0.047 | 0.23 |
| Level 2 | Low Cd emissions, 0.047-0.094 | 0.47 |
| Level 3 | Moderate Cd emissions, 0.095-0.019 | 0.94 |
| Level 4 | Appreciable Cd emissions, 0.02-0.037 | 1.88 |
| Level 5 | Substantial Cd emissions, 0.038-0.075 | 3.76 |
| Level 6 | Severe Cd emissions, 0.076-0.15 | 7.5 |
| Level 7 | Very severe Cd emissions, > 0.15 | 15 |

| Contamination | Pesticides- DDT | Points |
|---|---|---|
| Level 1 | Very low DDT emissions, < 0.093 | 0.1 |
| Level 2 | Low DOT emissions, 0.093-0.18 | 0.2 |
| Level 3 | Moderate DOT emissions, 0.19-0.37 | 0.4 |
| Level 4 | Appreciable DDT emissions, 0.38-0.74 | 0.7 |
| Level 5 | Substantial DDT emissions, 0.75-1.49 | 1.5 |
| Level 6 | Severe DDT emissions, 1.5-3.0 | 3 |
| Level 7 | Very severe DDT emissions, > 3 | 6 |

### V7. Heat

Heat can have disruptive consequences for the ecosystem and must therefore be regarded as contamination. Many production processes are associated with the evolution of heat, which is dissipated using cooling water or cooling towers. In more modern installations the choice will increasingly be made to put waste heat to beneficial use, in the form of district heating or the like. As a consequence this subcriterion will be able to occur less frequently in the future.

| Contamination | Heat | Points |
|---|---|---|
| Level 1 | Very low emission of heat, cooling relative to environment < 5 °C | 2 |
| Level 2 | Low emission of heat, cooling relative to environment 5-10 °C | 8 |
| Level 3 | Moderate emission of heat, cooling relative to environment 11-20 °C | 32 |
| Level 4 | Appreciable emission of heat, cooling relative to environment 21-50 °C | 128 |
| Level 5 | Substantial emission of heat, cooling relative to environment 51-100 °C | 512 |
| Level 6 | Severe emission of heat, cooling relative to environment 101-200 °C | 2,048 |
| Level 7 | Very severe emission of heat, cooling relative to environment > 200 °C | 8,192 |

### Waste

In the CML LCA method the waste component is differentiated into three subcriteria. These three subcriteria are maintained here unabridged; the only change is that the term chemical waste has been replaced by "hazardous waste", the term normally used today.

Since for the purposes of this criterion the waste is differentiated only according to amount and not according to harmfulness (the latter is done under contamination in the waste phase), a simple level ranking can suffice.

| No. | Final classification model | LCA term used by CML |
|---|---|---|
| A1 | Waste before processing | Waste before processing |
| A2 | Final waste | Final waste |
| A3 | Hazardous waste | Chemical waste |

This subdivision into three covers all aspects of the waste problem as far as quantities are concerned. Recyclable waste is no longer regarded as waste and thus falls under the criterion of recyclability. The harmfulness of the waste is assessed under the contamination criterion during the waste phase. In total seven performance levels are described.

### A1-A3 Waste

Waste for processing is defined as the total quantity of waste from a process. Some of this waste will be able to be processed or recycled, so that this portion will not be included in the final waste. The final waste is solely that waste with which nothing other can be done than burning or dumping. Since legislation is making dumping increasingly more difficult, the total quantity of final waste is expected to decrease ever further over the years. Hazardous waste is that waste which may not be dumped or may not be incinerated without provisos. There is a list of which waste has to be regarded as hazardous waste. The following table gives an assessment of the total quantity of waste which is not subjected to any further processing and thus has to be regarded as final waste and/or hazardous waste. The unit is percent by weight per 1,000 kg of end product.

| Waste | Waste before processing, final and hazardous waste | Points |
|---|---|---|
| Level 1 | Very small amount of waste, less than 10 % of end product | 10 |
| Level 2 | Small amount of waste, between 11 and 20 % of end product | 60 |
| Level 3 | Moderate amount of waste, between 21 and 40 % of end product | 120 |
| Level 4 | Appreciable amount of waste, between 41 and 80 % of end product | 240 |
| Level 5 | Substantial amount of waste, between 81 and 160 % of end product | 480 |
| Level 6 | Severe amount of waste, between 161 and 320 % of end product | 960 |
| Level 7 | Very severe amount of waste, more than 320 % of end product | 1,920 |

### Nuisance

In the CML LCA method the nuisance criterion is subdivided into four subcriteria. These four subcriteria have been taken over and modified and supplemented somewhat, as can be seen from the table below.

| No. | Final classification model | LCA term used by CML |
|---|---|---|
| Hl | Stench and odour | Stench and odour |
| H2 | Noise/vibration | Noise for user/environment |
| H3 | Disasters/external to process | Disasters (without health aspects) |
| H4 | Disasters/internal to process | |
| H5 | Light | (Light) |

### H1. Stench and odour

Stench and odour are two aspects of nuisance which are frequently underexposed, mainly because it is difficult to quantify them. As yet there is still no method available for quantifying stench and odour.

The Olf or decipol method is used for the indoor environment. These methods are suitable for use for determination of the air change rate, but are inadequate when it comes to detecting stench and odour.

Of necessity it has been elected to adopt subjective detection, which will be replaced as soon as a better ranking option is available.

| Nuisance | Stench and odour | Points |
|---|---|---|
| Level 1 | Very little nuisance caused by stench and odour, slight presence | 2 |
| Level 2 | Little nuisance caused by stench and odour, detectable | 4 |
| Level 3 | Moderate nuisance caused by stench and odour, irritant | 8 |
| Level 4 | Appreciable nuisance caused by stench and odour, unpleasant | 16 |
| Level 5 | Substantial nuisance caused by stench and odour, disruptive | 32 |
| Level 6 | Severe nuisance caused by stench and odour, nasal organ affected | 64 |
| Level 7 | Very severe nuisance caused by stench and odour, damage to nasal organ | 128 |

### H2. Noise/vibration

Noise and vibration are likewise two aspects of nuisance which are difficult to quantify and consequently are frequently underexposed. It is true that the method using decibels is usable, but this allows no assessment of vibration.

Here again for the time being it has of necessity been elected to adopt subjective detection, which will be replaced as soon as a better ranking option is available.

| Nuisance | Noise/vibration | Points |
|---|---|---|
| Level 1 | Very little nuisance caused by noise and/or vibration, slight presence | 2 |
| Level 2 | Little nuisance caused by noise and/or vibration, detectable | 4 |
| Level 3 | Moderate nuisance caused by noise and/or vibration, clearly present | 8 |
| Level 4 | Appreciable nuisance caused by noise and/or vibration, unpleasant | 16 |
| Level 5 | Substantial nuisance caused by noise and/or vibration, disruptive | 32 |
| Level 6 | Severe nuisance caused by noise and/or vibration, hearing/balance affected | 64 |
| Level 7 | Very severe nuisance caused by noise and/or vibration, damage to hearing/balance | 128 |

### H3. Process-external disasters

Process-external disasters are mainly determined by the type of substances which are being handled and the processes which take place in the various stages. The risk of disasters is expressed as percent by weight use of hazardous substances per 1000 kg material and/or product produced.

| Nuisance | Process-external disasters | Points |
|---|---|---|
| Level 1 | Very low risk, no hazardous substances, < 0.01 % | 2 |
| Level 2 | Low risk, use of hazardous substances very low, 0.011-0.05 % | 12 |
| Level 3 | Moderate risk, use of hazardous substances low, 0.051-0.1 % | 24 |
| Level 4 | Appreciable risk, use of hazardous substances, 0.11-1.0 % | 48 |
| Level 5 | Substantial risk, moderate use of hazardous substances, 1.1-10 % | 96 |
| Level 6 | Severe risk, extensive use of hazardous substances, 10-100 % | 192 |
| Level 7 | Very severe risk, large-scale use of hazardous substances, > 100 % | 384 |

### H4. Process-internal disasters

Process-internal disasters are mainly determined by the type of substances which are being handled and the processes which take place in the various phases. The risk of disasters is expressed as the number of hazardous processes which have to be performed per 1000 kg material and/or product produced.

| Nuisance | Process-internal disasters | Points |
|---|---|---|
| Level 1 | Very low risk, no hazardous processes, 1 or less | 2 |
| Level 2 | Low risk, very low number of hazardous processes used, 1-2 | 12 |
| Level 3 | Moderate risk, low number of hazardous processes used, 3-5 | 24 |
| Level 4 | Appreciable risk, use of hazardous processes, 6-10 | 48 |
| Level 5 | Substantial risk, moderate use of hazardous processes, 11-20 | 96 |
| Level 6 | Severe risk, extensive use of hazardous processes, 21-50 | 192 |
| Level 7 | Very severe risk, large-scale use of hazardous processes, > 50 | 384 |

### H5. Light

Light is a nuisance problem when it is emitted in an uncontrolled manner. The light aspect was not covered in the CML LCA method, but was added later and is addressed in some literature references but is missing in others.

| Nuisance | Light | Points |
|---|---|---|
| Level 1 | Very low degree of emission, no/virtually no light | 2 |
| Level 2 | Low degree of emission, light detectable | 4 |
| Level 3 | Moderate degree of emission, clearly detectable | 8 |
| Level 4 | Appreciable degree of emission, unpleasant | 16 |
| Level 5 | Substantial degree of emission, troublesome | 32 |
| Level 6 | Severe degree of emission, retina affected | 64 |
| Level 7 | Very severe degree of emission, damage to retina | 128 |

### Adverse effect on nature and landscape

An adverse effect on nature and landscape is a fairly complex event and cannot be expressed in a simple table with performance levels. It has therefore been elected to make this a separate criterion with three subcriteria. In the CML LCA method this adverse effect is part of the nuisance criterion.

| No. | Final classification model | LCA term used by CML |
|---|---|---|
| Aa1 | Space taken up | Space taken up |
| Aa2 | Type and complexity of ecosystem | Fragmentation (somewhat different interpretation) |
| Aa3 | Degree of restorability/disruption | Disruption |

### Aa1 Space taken up

The space taken up is defined as that space which is taken for infrastructure works to render production and extraction sites accessible and the space required for the production facilities and extraction sites themselves. Infrastructure works are to be understood as meaning roads, waterways, electricity, gas and oil lines, etc.

The space taken up is not all space taken for all extraction and production facilities in the world, but only for those extraction and production facilities assessed under G4.

| Adverse effect | Space taken up | Points |
|---|---|---|
| Level 1 | Very little space taken up, < 0.5 ha | 2 |
| Level 2 | Little space taken up, 0.5-1.0 ha | 4 |
| Level 3 | Moderate amount of space taken up, 1.1-2.0 ha | 8 |
| Level 4 | Appreciable amount of space taken up, 2.1-5.0 ha | 16 |
| Level 5 | Substantial amount of space taken up, 5.1-10.0 ha | 32 |
| Level 6 | Extensive amount of space taken up, 10.1-20.0 ha | 64 |
| Level 7 | Very extensive amount of space taken up, > 20 ha | 128 |

### Aa2. Type and complexity of ecosystem

What is assessed under type and complexity of the ecosystem is the degree of biodiversity and the extent to which this is disrupted. The score when a simple ecosystem is disrupted is lower than that when a complex ecosystem is disrupted. Extraction of sand from the Sahara is regarded as a less severe disruption of the ecosystem than is extraction of wood from a tropical rain forest.

The complexity of the ecosystem is assessed on the basis of the number of species of plants and animals which it may contain. It is assumed that the number of species of plants can be doubled in order to obtain the total number of species of plants and animals. To make this workable in practice, it has been translated into types of situations which can arise.

| Adverse effect | Type and complexity of ecosystem | Points |
|---|---|---|
| Level 1 | Very small number of species in the ecosystem, monocultures, < 50 species Pasture close to towns, grasslands, maize fields, agricultural acreage | 2 |
| Level 2 | Small number of species in the ecosystem, 50-100 species Fields, agriculture in a more natural environment | 4 |
| Level 3 | Moderate number of species in the ecosystem, 101-200 species Rich diversity of woods, moors and fields | 8 |
| Level 4 | Appreciable number of species in the ecosystem, 201-500 species Natural regions with substantial variation | 16 |
| Level 5 | Large number of species in the ecosystem, 501-800 species Natural regions, combination of water and vegetation | 32 |
| Level 6 | Very large number of species in the ecosystem, 801-1200 species Primeval forests, mangroves | 64 |
| Level 7 | Extremely large number of species in the ecosystem, > 1,200 species Tropical rainforests | 128 |

### Aa3. Degree of restorability of the ecosystem/disruption

The degree of restorability is determined on the basis of the degree of disruption. It is assumed that the disruption is always such that all or virtually all vegetation and animals will disappear during the disruption. If no further adverse effect has taken place, complete recovery can take place in the case of ecosystems which are not too complex. In the case of complex ecosystems (level 4 and above in Table A2) there will never be able to be complete recovery because only a limited wealth of species can be introduced by planting. Possible complete recovery will then take so long that recovery can be considered to be incomplete over the entire period under consideration here.

The degree of disruption is determined on the basis of number of species, pollution and adverse effects on soil structure and groundwater flows.

| Adverse effect | Degree of restorability of ecosystem/disruption | Points |
|---|---|---|
| Level 1 | Very little disruption: complete recovery possible | 2 |
| Level 2 | Slight pollution, no adverse effect on soil structure and no adverse effect on groundwater flows; recovery possible | 20 |
| Level 3 | Slight pollution or adverse effect on soil structures and no adverse effect on groundwater flows; limited recovery possible | 40 |
| Level 4 | Moderate pollution or adverse effect on soil structures, no adverse effect on groundwater flows; limited recovery possible | 80 |
| Level 5 | Slight pollution or adverse effect on soil structures and adverse effect on groundwater flows; no recovery possible | 160 |
| Level 6 | Moderate pollution and/or adverse effect on soil structures and adverse effect on groundwater flows; no recovery possible | 320 |
| Level 7 | Severe pollution and/or adverse effect on soil structures and adverse effect on groundwater flows; no recovery possible | 640 |

### Energy

In the CML LCA method the energy criterion has only two subcriteria. These two subcriteria have been supplemented by a further important subcriterion, namely the type of energy carrier. It is extremely important to distinguish between lignite-fired, coal-fired, oil-fired, gas-fired, hydroelectric and nuclear energy sources. In principle, the distinction between these energy sources ought to be expressed in the contamination criterion. Since data for the total energy consumption and the contamination are usually known only per branch of industry, it is very easy in this way to make a distinction between clean and dirty energy carriers.

It is desirable to consider this aspect per stage, but unfortunately a large number of data are still lacking in this area, which is why it is possible only to assess the total energy consumption for extraction, production and transport to the production facility. Other data are only sporadically available. It is for this reason that energy is included in the matrix only under the raw material extraction stage and in particular under the construction stage, with all data being summarised under the latter.

| No. | Final classification model | LCA term used by CML |
|---|---|---|
| E1 | Exhaustion of non-renewable energy carriers | Exhaustion of non-renewable energy carriers |
| E2 | Type of energy carrier | - |
| E3 | Total quantity of energy consumed | Total quantity of energy consumed |

### E1. Exhaustion of non-renewable energy carriers

The degree of exhaustion of non-renewable energy carriers is assessed here on the basis of world stocks assuming the current rate of exhaustion. It is important to know which energy carrier is being used. If this is not known it is taken to be the so-called Euromix, an average of all energy carriers used in Europe for power generation.

| Energy | Exhaustion of non-renewable energy carriers | Points |
|---|---|---|
| Level 1 | Hydroelectric power (virtually infinite) | 1 |
| Level 2 | Coal (stocks for about 200 years) | 5 |
| Level 3 | Lignite (stocks for about 200 years) | 5 |
| Level 4 | Natural gas (stocks for about 50-80 years) | 20 |
| Level 5 | Euromix | 25 |
| Level 6 | Oil (stocks for about 30-50 years) | 33 |
| Level 7 | Nuclear energy (stocks for about 20-50 years) | 50 |

### E2. Type of energy carrier

The type of energy carrier is the determining factor for the pollution which is caused by energy generation.

| Energy | Type of energy carriers | Points |
|---|---|---|
| Level 1 | Permanently generated energy (wind and/or solar energy) | 2 |
| Level 2 | Water or tidal energy | 4 |
| Level 3 | Natural gas | 8 |
| Level 4 | Oil | 16 |
| Level 5 | Coal | 32 |
| Level 6 | Lignite | 64 |
| Level 7 | Nuclear energy | 128 |

### E3. Total amount of energy consumed

The total amount of energy consumed must be taken into consideration because exhaustion and pollution caused by energy consumption can be determined from this.

| Energy | Total amount of energy consumed | Points |
|---|---|---|
| Level 1 | 0-10 GJ/tonne | 10 |
| Level 2 | 11-20 GJ/tonne | 20 |
| Level 3 | 21-40 GJ/tonne | 40 |
| Level 4 | 41-80 GJ/tonne | 80 |
| Level 5 | 81-160 GJ/tonne | 160 |
| Level 6 | 161-320 GJ/tonne | 320 |
| Level 7 | > 321 GJ/tonne | 640 |

### Recyclability

This criterion has three subcriteria in the CML LCA method. Here it has been elected to adopt a completely new subdivision of this criterion into four subcriteria, which have been taken from the draft DIN (Deutsche Industrie Norm) for definitions of recycling.

What is assessed is not the possibility of recycling, but actual recycling, which can differ appreciably from the (technical) possibilities.

The various subcriteria are all taken into consideration. For example, if there is no recycling and no further use, these are both scored at level seven. Unless parts of product/building components are assessed, percentages will be used and, once again, these will be summed, ultimately providing an assessment of 100 % of the product/building component. Reprocessing and further processing are dealt with in a comparable manner. If nothing is recyclable, this criterion scores level 7 for all four subcriteria.

| No. | Final classification model | LCA term used by CML |
|---|---|---|
| He1 | Re-use, product level | Recycling of complete product |
| He2 | Further use, product level | Recycling of parts (different interpretation) |
| He3 | Reprocessing, raw material level | Recyclability of materials |
| He4 | Further processing, raw material level | - |

### He1. Re-use, product level

The re-use of products/building components is the highest form of recycling. However, there are subtle distinctions to be made. It will seldom prove possible to re-use a product/building component again without modifications. What is assessed under this subcriterion is the extent to which the original state of the product/building component can be ensured in its original application or the extent to which additions are needed to enable the product/building component to be used again.

The percentages given are always percentages by weight.

Environmental impact points are not assigned for this aspect; instead a factor is determined by which the above criteria are multiplied.

| Recycling | Re-use, product level | Factor |
|---|---|---|
| Level 1 | Complete re-use without additions or with minor additions of < 5 % or virtually complete re-use, > 90 % | 0.33 |
| Level 2 | Complete re-use with additions of 5-10 % or substantial re-use, 90-80 % | 0.40 |
| Level 3 | Complete re-use with additions of 11-20 % or partial re-use, 81-70 % | 0.50 |
| Level 4 | Complete re-use with significant additions of 21-40 % or restricted amount re-used, 71-50 % | 0.63 |
| Level 5 | Complete re-use with expansions and/or additions of > 40 % or slight amount re-used, 51-30 % | 0.77 |
| Level 6 | Very slight amount re-used, < 30 % | 0.91 |
| Level 7 | No re-use | 1.00 |

### He2. Further use, product level

Further use of products/building components is a form of low-grade recycling. In the main there is a saving in materials compared with situations where there would be no further use. However, here again subtle distinctions must be made. It will seldom be possible to re-use a product/building component again without modifications. What is assessed under this subcriterion is the extent to which the original state of the product/building component can be ensured.

The percentages given are always percentages by weight.

Environmental impact points are not assigned for this aspect. Instead of this, as for the previous aspect, a factor is determined by which the above criteria are multiplied.

| Recycling | Further use, product level | Factor |
|---|---|---|
| Level 1 | Complete further use without additions or with minor additions of < 5 % or virtually complete further use, > 90 % | 0.56 |
| Level 2 | Complete further use with additions of 5-10 % or substantial further use, 90-80 % | 0.63 |
| Level 3 | Complete further use with additions of 11-20 % or partial further use, 81-70 % | 0.71 |
| Level 4 | Complete further use with significant additions of 21-40 % or restricted amount further used, 71-50 % | 0.83 |
| Level 5 | Complete further use with expansions and/or additions of > 40 % or slight amount further used, 51-30 % | 0.91 |
| Level 6 | Very slight amount further used, < 30 % | 0.95 |
| Level 7 | No further use | 1.00 |

### He3. Reprocessing, raw material level

Reprocessing, raw material level, is defined as the repeated use of collected building and demolition waste and production waste in a similar production process. The waste material is processed as raw material or as semi-finished product to produce a similar product.

What is assessed is actually what is recycled, not what is currently technically possible. The substantial difference between what is technically possible and day-to-day practice is usually made up of two factors: the costs and profitability on the one hand and the distribution and collection network on the other.

The levels indicate the percentage that is actually collected and reprocessed in the production process. The result obtained here is not environmental impact points but a factor. It is assumed that the raw material accounts for about 20 % of the total environmental impact of a product. If about 80 % of this raw material can be saved, there is then a 16 % reduction in the environmental impact. The percentage given passes as raw material through the entire process of all life stages again, as a result of which the original raw materials and the recycled raw materials or semi-finished products become composite products and must be assessed as such.

By way of example: about 94 % of the aluminium in the building sector is collected and is reintroduced as raw material into the process; this consumes appreciably less energy and other aspects of the production process are also different. Aluminium obtained in this way is assessed as an independent raw material and aluminium from recycling is qualified as aluminium with a lower environmental impact. However, there is no difference between new and recycled aluminum; it comes from the factory as one product. About 50 % of all newly produced aluminium comes from recycling. Consequently, aluminium is assigned an environmental impact of a composite product; 50 % new aluminium from the process and 50 % recycled aluminium from the process. The resultant is the environmental impact which can be expected.

| Recycling | Reprocessing, raw material level | Factor |
|---|---|---|
| Level 1 | All building, demolition and production waste is collected, > 90 % | 0.80 |
| Level 2 | Virtually all building, demolition and production waste is collected, 90-80 % | 0.84 |
| Level 3 | The major proportion of building, demolition and production waste is collected, 81-70 % | 0.86 |
| Level 4 | A significant proportion of building, demolition and production waste is collected, 71-50 % | 0.90 |
| Level 5 | Some of the building, demolition and production waste is collected, 51-30 % | 0.94 |
| Level 6 | Hardly any building, demolition and production waste is collected, 31-10 % | 0.98 |
| Level 7 | Building, demolition and production waste is not collected, < 10 % | 1.00 |

### He4. Further processing, raw material level

Further processing, raw material level, is defined as the use of collected building and demolition waste and production waste in a production process which has not already been performed. The waste material is generally processed to give a lower grade product. This is usually accompanied by a reduction in the value of the material.

What is assessed is the actual recycling of the material, not what is currently technically possible. The substantial difference between what is technically possible and day-to-day practice usually lies in two factors, i.e. costs and profitability and the distribution and collection network.

The levels give the percentage of what is actually collected and reprocessed in the production process. The result obtained here is not environmental impact points, but a factor. The percentage given passes as raw material through the entire process of all life stages again, as a result of which the original raw materials and the recycled raw materials or semi-finished products become composite products and are assessed as such.

By way of example: about 50 % of all the concrete which becomes available on demolition in the building sector is collected and sent to a rubble crusher. The product thus produced is used again as a raw material and added to a different process. It is assessed as a raw material in its own right and is used as an alternative to gravel in concrete constructions. Concrete containing concrete rubble granulate is thus assigned an environmental impact for a composite product.

| Recycling | Further processing, raw material level | Factor |
|---|---|---|
| Level 1 | All building, demolition and production waste is collected, > 90 % | 0.85 |
| Level 2 | Virtually all building, demolition and production waste is collected, 90-80 % | 0.88 |
| Level 3 | The major proportion of building, demolition and production waste is collected, 81-70 % | 0.90 |
| Level 4 | A significant proportion of building, demolition and production waste is collected, 71-50 % | 0.93 |
| Level 5 | Some of the building, demolition and production waste is collected, 51-30 % | 0.96 |
| Level 6 | Hardly any building, demolition and production waste is collected, 31-10 | 0.99 |
| Level 7 | Building, demolition and production waste is not collected, < 10 % | 1.00 |

### Reparability

In the CML LCA method there is no further subdivision of this aspect or criterion. Here it has been elected to adopt a subdivision, specifically into two subcriteria. The results for these two subcriteria are multiplied by one another and together added to one. The resultant of this is then the factor by which the environmental impact must be multiplied.

| No. | Final classification model | LCA term used by CML |
|---|---|---|
| R1 | Maintenance cycle | - |
| R2 | Percentage replacement | - |

### R1. Maintenance cycle

What is important for the environmental impact of a material or product is how often maintenance has to be carried out.

| Reparability | Maintenance cycle | Factor |
|---|---|---|
| Level 1 | No maintenance, maintenance-free for life | 0 |
| Level 2 | Maintenance cycle 1/life | 1 |
| Level 3 | Maintenance cycle 2/life | 2 |
| Level 4 | Maintenance cycle 3/life | 3 |
| Level 5 | Maintenance cycle 4-5/life | 5 |
| Level 6 | Maintenance cycle 6-8/life | 8 |
| Level 7 | Maintenance cycle > 8/life | 12 |

### R2. Percentage replacement

What is important for the environmental impact of a material or product is not only how often maintenance has to be carried out but also how much material on average has to be consumed each time maintenance is carried out (replacement or addition).

| Reparability | Percentage replacement | Factor |
|---|---|---|
| Level 1 | No maintenance, maintenance-free for life | 0 |
| Level 2 | Replacement < 5 %/life | 0.05 |
| Level 3 | Replacement 6-10 %/life | 0.10 |
| Level 4 | Replacement 11-20 %/life | 0.20 |
| Level 5 | Replacement 21-30 %/life | 0.30 |
| Level 6 | Replacement 31-50 %/life | 0.50 |
| Level 7 | Replacement > 50 %/life | 1.00 |

### Life

The life component actually ought to consist of two subcriteria, i.e. the technical life, to be assessed in accordance with life catalogues, and the actual useful life, which is also termed the economic life. One problem with this subdivision is, however, that the manufacturer can not be made responsible for the use of his product in this way. If a product is subject to fashion or if it is simply the case that the wrong product for the application has been chosen, this cannot be ascribed to the product.

The calculations will thus be based on the technical life, the basic assumption chosen being that the life of a building is about 75 years. Some materials and products can easily have a life in excess of this, but this maximum is nevertheless specified for these.

For calculation of alternatives in a known application use can be made of the economic life. To this end the method will have to leave open the option of entering the life as an arbitrary unit.

| Life | Technical life of material/product/building component | Factor |
|---|---|---|
| Level 1 | Life > 75 years | 75/75 |
| Level 2 | Life 61-75 years | 67/75 |
| Level 3 | Life 46-60 years | 53/75 |
| Level 4 | Life 31-45 years | 33/75 |
| Level 5 | Life 21-30 years | 25/75 |
| Level 6 | Life 10-20 years | 15/75 |
| Level 7 | Life < 10 years | 5/75 |

### 3. Assessment formula

A number of preliminary operations are required in order to be able to compile the assessment formula. First of all the various subcriteria of an environmental or health criterion must be aggregated to obtain one environmental impact point number per criterion. The criteria are then weighed against one another.

### Aggregation of ecotoxicity subcriteria

- raw materials:: (G1+G2+G3+G4) = ΣG
- contamination:: {[V1_{SO2}+V1_{NOx})*10]+[(V2_{NOx}+V2_{P})*5]+[(V3_{CO2}+V3_{CFC})*2.5]+[V4_{CFC}*100]+[(V5_{PAHC}+V5_{VOC}+V5_{SO2}+V5_{particulates})*5]+[(V6_{Pb}+V6_{Cd}+V6_{DDT})*25]+V7} = ΣV
- waste:: A = ΣA
- nuisance:: (H1+H2+H3+H4+H5) = ΣH
- adverse effect:: (Aa1+Aa2+Aa3) = ΣAa
- energy:: (E1+E2+E3*25) ΣE
- recycling:: (He1 + He2 + He3 + He4) = ΣHe
- reparability:: [1+(Re1*Re2)] = ΣRe
- life:: L1 or L2 = ΣL

### Formula per stage

- raw material extraction:: (ΣG*n_{G})+(ΣV*nᵥ)+(ΣA*n_{A})+(ΣH*n_{H})+(ΣAa*n_{Aa})+(ΣE*n_{E}) = ΣΣGW
- production of material:: (ΣV*nᵥ)+(ΣA*n_{A}+(ΣH*nH)+(ΣH*n_{H})+(ΣAa*n_{Aa}) = ΣΣPM
- construction of building:: (ΣV*nᵥ)+(ΣH*n_{H})+(ΣE*n_{E}) = ΣΣ*CG
- use/maintenance:: (ΣV*nᵥ)+(ΣH*n_{H}) = ΣΣGO
- demolition of building:: (ΣV*nᵥ)+(ΣA*n_{A})+(ΣH*n_{H}) = ΣΣSG
- waste treatment:: (ΣV*nᵥ)+(ΣH*n_{H}) = ΣΣAV

### Complete formula

- formula in abbreviated form:: (ΣΣGW+ΣΣPM+ΣΣCG+ΣΣGO+ΣΣSG+ΣΣAV)*ΣHe*ΣR*ΣL =
environmental impact/unit
environmental impact/unit * quantity of material required = environmental impact in application
- formula in full:: {Σ^{G}_{GW}{{(G1+G2+G3+G4)*n_{G}} + Σ^{V}_{GW+PM+CG+GO+SG+AV}
{[(V1SO2+V1NOx))*10]+[(V2NOx+V2p)*5]+[(V3CO2+V3CFC)*2.5]+
[V4_{CFC}*100]+[(V5_{PAHC}+V5_{VOC}+V5_{SO2}+V5_{particulates})*5]+
[(V6_{Pb}+V6_{Cd}+V6_{DDT})*25]+V7} *n_{V} + Σ^{A}_{GW+PM+SG} {A*n_{A} } +
Σ^{H}_{GW+PM+CG+GO+SG+AV} {(H1+H2+H3+H4+H5)*n_{H} } +
Σ^{Aa}_{GW+PM} {(Aa1+Aa2+Aa3)*n_{Aa} } +
ΣE_{GW+CG} {(E1+E2+E3*25)*n_{E} }} *
(He1 + He2 + He3 + He4) *
[1+(Re1*Re2)] *
L1 = ΣΣΣ environmental impact/unit

In practice, stages CG (construction of building), GO (use and maintenance), SG (demolition of building) and AV (waste treatment) are assessed at the same time, so that the formula consists of three components (life stages), i.e.: GW (raw materials extraction), PM (production of materials) and the combination of the other stages CG/AW (construction of building to waste treatment).

### Legend for equations

- G1: exhaustion of scarce biotic raw materials
- G2: exhaustion of abiotic raw materials
- G3: rate of exhaustion of raw materials
- G4: location/extraction site of raw materials
- V1: acidification
- V2: contamination with fertilisers
- V3: greenhouse effect
- V4: attack on the ozone layer
- V5: summer and winter smog
- V6: heavy metals and pesticides
- V7: heat
- A: total waste
- H1: stench and odour
- H2: noise/vibration
- H3: process-external disasters
- H4: process-internal disasters
- H5: light
- Aa1: space taken up
- Aa2: type and complexity of ecosystem
- Aa3: degree of recoverability/disruption
- E1: exhaustion of non-renewable energy sources
- E2: type of energy carrier
- E3: total quantity of energy
- He1: re-use of building component
- He2: further use of building component
- He3: re-use of material
- He4: further use of material
- R1: maintenance cycle
- R2: percentage replacement
- L1: technical life
- L2: economic life
- GW: raw material extraction phase
- PM: production of material phase
- CG: construction of building phase
- GO: use and maintenance phase
- SG: demolition of building phase
- AV: waste processing phase
- n: weighting factor/criterion

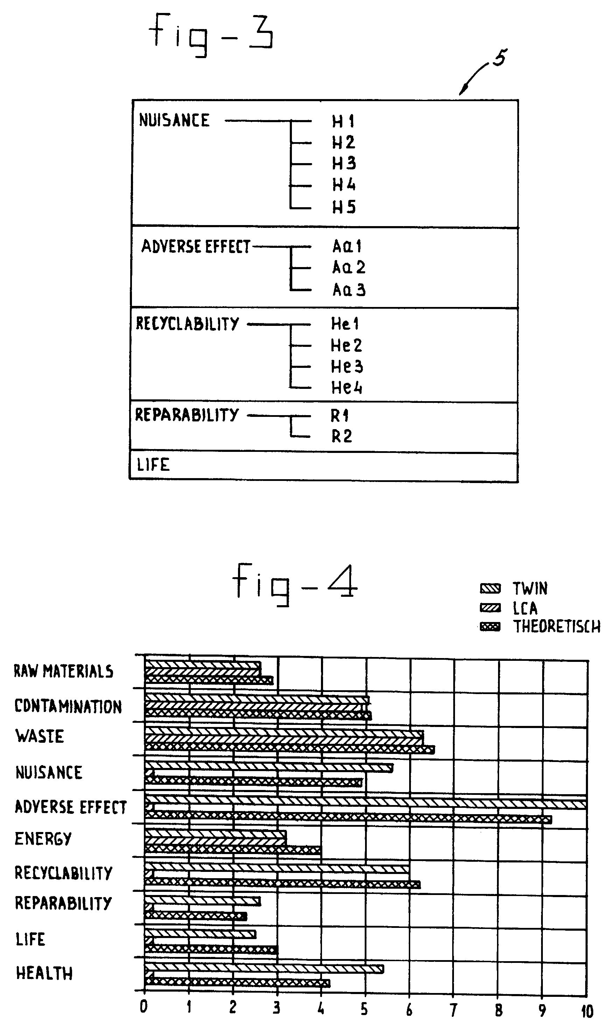

Figure 2 shows an example of the content of the quantitative module 4, whilst Figure 3 shows an example of the content of the qualitative module 5. The symbols used in these figures have been explained in more detail above in the description of the invention.

### Practical applications

By means of calculations using the model it has proved possible to compare the environmental impacts caused by building materials in building components and even by entire dwellings or offices.

On the basis of an interim result, a computer program with which the environmental performances of dwellings can be computed and compared with one another has been developed for the Stichting Stuurgroep Experimenten Volkshuisvesting (SEV; Steering Group for Experimental Public Housing Foundation).

Figure 4 shows a comparison of the results which can be produced by equipment according to the invention with the results obtained using equipment which works with the LCA method. The crosshatched bar shows the actual environmental impact of a product (which in practice will possibly be known only after 50 years). It can clearly be seen from Figure 4 that important data cannot be processed using the LCA method because these are not yet quantitatively known, whereas at least rough approximations can be given by means of the method outlined here.

A major advantage of the model presented here compared with existing models such as the BOOM DCBA method, the SEV preference method, the SIB (Schweizerische Interessengemeinschaft für Baubiologie/Bauökologie; Swiss Syndicate for Building Biology/Building Ecology) Positive List, the Intron method as developed for the Environmental Advisory Council for the Building Sector and the LCA method devised by the Centre for Environmental Science, University of Leiden, lies in the possibility of comparing not just building materials with one another but also building components and entire buildings. Other methods do not offer this facility as yet. In addition, integral weighing up on the basis of the best possible data from the various studies (quantitative and qualitative data) is possible.

## Claims

1. Equipment for determining the environmental impact of objects in the building sector, provided with a processing unit (1) and display means (2), connected to the processing means (1), input means (3) and a quantitative module (4) which is connected to the processing means (1) and is provided with quantitative environmental impact data for at least one object, the processing means (1) being equipped to compute an environmental impact value as a function of the environment impact data, characterised in that the equipment also comprises a qualitative module (5) which is connected to the processing means (1), the qualitative module (5) containing qualitative data on objects for which as yet no quantitative environmental impact data are known, which qualitative data have been compiled in the form of performance scales, a value being assigned to each performance scale, and wherein the processing means are equipped also to compute the environmental impact value as a function of the values of the performance scales for the qualitative data.

2. Equipment according to Claim 1, characterised in that the processing means are equipped to move qualitative data from the qualitative module (5) to the quantitative module (4) as soon as environmental impact data which have become available for these have been assigned.

3. Equipment according to Claim 1 or 2, characterised in that the processing means are equipped to remove quantitative data from the quantitative module (4), if the environmental impact data already assigned thereto are removed, and to move them to the qualitative module (5) to be compiled in the form of performance scales.

4. Equipment according to one of the preceding claims, characterised in that the processing means compute the environmental impact value by summing environmental impact data, one or more of the values from the performance scales being used as weighting factor.

5. Equipment according to one of the preceding claims, characterised in that the quantitative module (4) contains environmental impact data in respect of:
- raw materials;
- contamination;
- waste and
- energy

6. Equipment according to one of the preceding claims, characterised in that the qualitative module (5) contains performance scales with respect to:
- nuisance;
- adverse effects;
- recyclability;
- reparability;
- life and
- health.

7. Equipment according to Claim 6, characterised in that the values from the following performance scales are used as a multiplication factor: recyclability, reparability and life.
